Europäisches Patentamt

European Patent Office

Office européen des brevets

(11) Veröffentlichungsnummer: **0 453 654 A1**

## (12) EUROPÄISCHE PATENTANMELDUNG

(21) Anmeldenummer: 90125198.3

(22) Anmeldetag: 21.12.90

(51) Int. Cl.5: **F16M 7/00, H05K 5/02**

(30) Priorität: 27.04.90 DE 4013644

(43) Veröffentlichungstag der Anmeldung:
30.10.91 Patentblatt 91/44

(84) Benannte Vertragsstaaten:
CH DE FR GB IT LI

(71) Anmelder: **BICC-VERO ELECTRONICS GMBH**
**Carsten-Dressler-Strasse 10**
**W-2800 Bremen 61(DE)**

(72) Erfinder: **Borschewski, Dietmar**
**Woltmershauserstrasse 287**
**W-2800 Bremen 1(DE)**
Erfinder: **Schröder, Rainer**
**Trelleborgerstrasse 14**
**W-2800 Bremen 77(DE)**

(74) Vertreter: **Bohnenberger, Johannes, Dr. et al**
**Meissner, Bolte & Partner**
**Widenmayerstrasse 48 Postfach 86 06 24**
**W-8000 München 86(DE)**

(54) **Gehäuse-Aufstellfuss.**

(57) Es ist ein Aufstellfuß für ein Gehäuse bekannt, der ein Lager zum schwenkbeweglichen Lagern des Aufstellfußes aufweist, wobei das Lager so ausgebildet ist, daß der Aufstellfuß mindestens zwischen einer Null-Position, in welcher er im wesentlichen vollständig in einem Gehäuse aufgenommen ist, und einer Aufstellposition verschwenkbar ist. In der Aufstellposition ragt eine Fußfläche aus dem Gehäuse heraus, so daß das Gehäuse auf einer Unterlage aufstellbar ist. Es sind Arretiereinrichtungen zum lösbaren Arretieren des Aufstellfußes in einer Null-Position und der Aufstellposition vorgesehen. Derartige Aufstellfüße klappen leicht versehentlich ein. Es wird vorgeschlagen, die Arretiereinrichtungen derart auszubilden, daß ein Lösen der Arretierung um den Aufstellfuß von seiner Aufstellposition herauszubewegen, nur durch Bewegen des Aufstellfußes in eine Richtung bewirkbar ist, welche entgegen einer von der Unterlage auf die Fußfläche wirkenden Kraft gerichtet ist.

Fig. 1

Die Erfindung betrifft einen Aufstellfuß für ein Gehäuse, insbesondere für ein 19"-Tischgehäuse.

Zur Aufnahme von elektronischen Bauteilen dienen Gehäuse, die im allgemeinen an ihren Frontseiten mit Anzeigeinstrumenten und Bedienungselementen versehen sind. Wenn ein solches Gehäuse auf einer Unterlage, z. B. auf einem Tisch steht, so ist der Abstand zwischen der Unterlage und den untersten Bedienungselementen oftmals relativ gering, so daß diese nur schlecht zugänglich sind. Darüber hinaus ist es zur leichteren Ablesbarkeit der Anzeigeinstrumente oftmals erwünscht, das Gehäuse schräg zur Unterlage zu stellen. Andererseits wird in manchen Fällen gewünscht, mehrere solche Gehäuse übereinander stapeln zu können oder sie aber in einen Einbauschrank einzubauen, wobei dann die Unterseiten der Gehäuse möglichst flach sein sollen, so daß fest angebrachte Aufstellfüße nicht erwünscht sind.

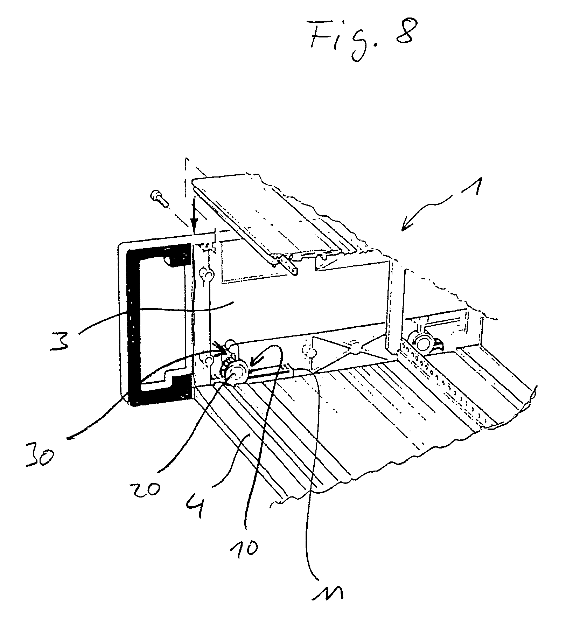

Unter der Bezeichnung KM7 wird von der Anmelderin ein Gehäuse vertrieben, welches mit Aufstellfüßen versehen ist, die in Fig. 8 gezeigt sind. Diese Aufstellfüße 10 sind an einer Seitenwand 3 eines Gehäuses 1 mittels eines Lagers 20 schwenkbar angebracht. Bei der in Fig. 8 gezeigten Schwenkposition des Aufstellfußes 10 ist dessen Fußfläche 11 unter die Außenfläche des Bodens 4 bis in das Gehäuseinnere hinein hochgeschwenkt. In dieser Position wird der Aufstellfuß 10 mittels einer Arretiereinrichtung 30 gehalten, welche aus einem Federelement besteht, das auf einer geriffelten Umfangsfläche des Fußes 10 aufliegt. Verschwenkt man den Aufstellfuß 10, so daß seine Fußfläche 11 senkrecht nach unten ragt, so hält die Arretiereinrichtung 30 den Fuß 10 in dieser Position fest.

Bei der bekannten Anordnung wird es als nachteilig angesehen, daß der Aufstellfuß 10 relativ leicht aus seiner Aufstellposition in die Null-Position, bei welcher die Fußfläche 11 in das Gehäuse eingeklappt ist, versehentlich verschwenkbar ist, was beispielsweise dann geschehen kann, wenn das Gehäuse auf seinen Aufstellfüßen über einen Tisch gezogen wird und der Aufstellfuß mit seiner Fußfläche 11 hängen bleibt.

Der Erfindung liegt die Aufgabe zugrunde, einen Aufstellfuß der eingangs genannten Art dahingehend weiterzubilden, daß bei einfachem Aufbau und Bedienungsweise eine sichere Aufstellposition erzielbar ist.

Diese Aufgabe wird bei einem Aufstellfuß der eingangs genannten Art durch die im Kennzeichen des Patentanspruches 1 angegebenen Merkmale gelöst.

Ein wesentlicher Punkt der Erfindung liegt darin, daß die Arretiereinrichtung durch das Gewicht des Gehäuses in die Arretierstellung gebracht und nur durch Bewegen des Fußes entgegen dieser Kraft - man zieht also den Fuß aus dem Gehäuse heraus - lösbar ist.

Vorzugsweise umfaßt das Lager ein Lagerauge im Aufstellfuß (oder im Gehäuse) und einen Lagerzapfen am Gehäuse (bzw. am Aufstellfuß). Das Lagerauge ist vorzugsweise als Langloch ausgebildet, in welchem der Lagerzapfen so sitzt, daß er in eine Richtung entlang der langen Achse des Langloches bewegbar ist. Die lange Achse des Langloches verläuft in der Längsrichtung des Aufstellfußes, also senkrecht zur Aufstellunterlage, so daß der Lagerzapfen in der Aufstellposition am einen Ende des Langloches anliegt.

Vorzugsweise sind Federeinrichtungen vorgesehen, die den Aufstellfuß mit einer Kraft in derselben Richtung beaufschlagen, wie sie durch das Gewicht des Gehäuses beim Aufstellen auf einer Unterlage wirkt. Auf diese Weise verbleibt der Aufstellfuß in seiner Arretierposition auch dann, wenn das Gehäuse von der Unterlage hochgehoben wird. Zum Lösen der Arretierung muß man also die Kraft der Feder überwinden, um den Aufstellfuß aus dem Gehäuse herauszuziehen.

Die Arretiereinrichtungen sind - allgemein ausgedrückt - als Kombination von Nase und Kerbe ausgebildet. Vorzugsweise umfassen die Arretiereinrichtungen einen oder mehrere am Gehäuse befestigte Zapfen und eine oder mehrere im Fuß angebrachte, einseitig offene Kerben. Selbstverständlich kann die Anbringung auch umgekehrt erfolgen. Zapfen und Kerbe sind so angebracht, daß der Zapfen in der Aufstellposition in der Kerbe einrastet und zum Lösen der Arretierung der Fuß so bewegt wird, daß der Zapfen aus der Kerbe herausrutscht.

Vorzugsweise umfaßt der Aufstellfuß zwei Fußflächen, die verschieden weit vom Lager entfernt sind, wobei die Arretiereinrichtungen ebenfalls doppelt ausgebildet sind, so daß der Fuß in zwei Richtungen arretierbar ist. Dadurch kann das Gehäuse in zwei verschiedenen Höhen (bzw. Neigungen) aufgestellt werden. Selbstverständlich ist es auch möglich, noch mehr Aufstellpositionen bzw. -Höhen vorzugeben, wenn die Anzahl der Fußflächen und der Arretierungen vergrößert wird.

Um den Aufstellfuß in einer Null-Position zu halten, bei welcher der gesamte Aufstellfuß in das Innere des Gehäuses eingeschwenkt ist, sind ebenfalls Arretiereinrichtungen vorgesehen. Diese können zwar auch zusammen mit den erstgenannten Arretiereinrichtungen ausgebildet sein, jedoch ist es von Vorteil, wenn diese Arretiereinrichtungen gesondert ausgebildet sind. Dadurch kann man die zusätzlichen Arretiereinrichtungen als einfache Schnapp-Rasten ausbilden, die durch einen gewissen, kleinen Kraftaufwand lösbar sind.

In jedem Fall ist es von Vorteil, wenn der Aufstellfuß symmetrisch zu seiner Schwenkebene derart ausgebildet ist, daß er an einer beliebigen Gehäuseseitenwand anbringbar ist. Dadurch ergibt sich eine erhebliche Verringerung des Herstellungsaufwandes.

Weitere wesentliche Merkmale ergeben sich aus den Unteransprüchen und der nachfolgenden Beschreibung bevorzugter Ausführungsformen der Erfindung, die im folgenden anhand von Abbildungen näher erläutert werden. Hierbei zeigen

Fig. 1  eine Draufsicht auf einen Aufstellfuß gemäß einer ersten Ausführungform der Erfindung,

Fig. 2  einen Schnitt entlang der Linie II-II aus Fig. 1,

Fig. 3  eine Draufsicht auf eine besonders bevorzugte Ausführungsform der Erfindung in der Darstellung ähnlich der nach Fig. 1, wobei der Aufstellfuß in das Gehäuse eingebracht ist,

Fig. 4  einen schnitt entlang der Linie IV-IV,

Fig. 5  einen Schnitt entlang der Linie V-V aus Fig. 3,

Fig. 6 und 7  den Aufstellfuß in der Darstellung nach Fig. 3 in zwei verschiedenen Aufstellpositionen, und

Fig. 8  eine perspektivische Darstellung eines Gehäuseteils mit Aufstellfuß nach dem Stand der Technik.

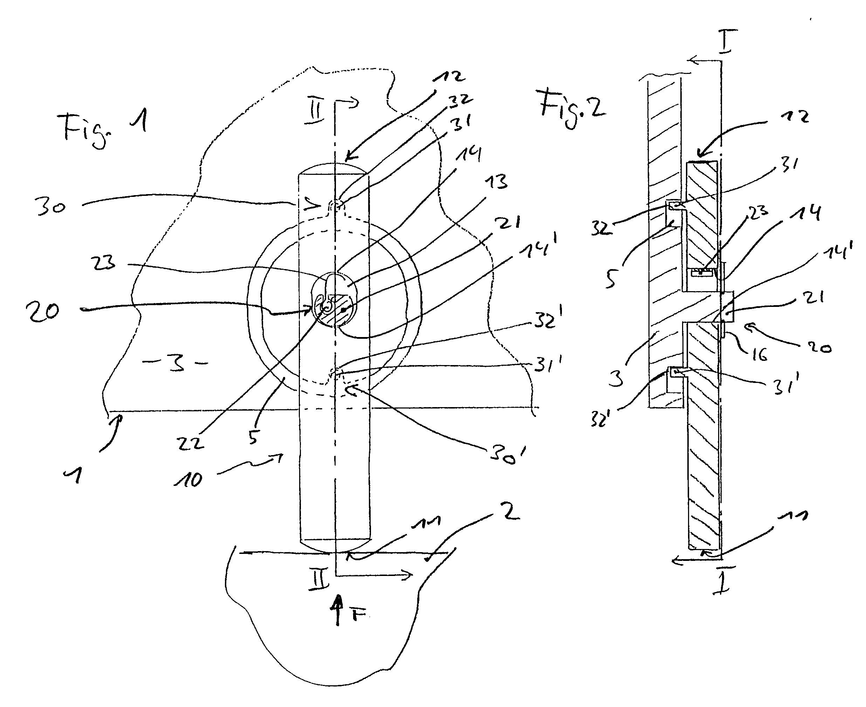

Bei der in den Fig. 1 und 2 gezeigten Ausführungsform der Erfindung weist der als länglicher Quader ausgebildeter Aufstellfuß 10 an zwei einander gegenüberliegenden Seiten Fußflächen 11 und 12 auf. Im Aufstellfuß 10 ist ein Auge 13 ausgebildet, welches als Langloch geformt ist. Die lange Achse des Auges 13 verläuft senkrecht zu den Fußflächen 11 und 12. Das Auge 13 liegt näher bei der Fußfläche 12 als bei der Fußfläche 11.

An einer Seitenwand 3 eines Gehäuses 1 ist ein, in das Innere des Gehäuses ragender, Schwenkzapfen 21 vorgesehen. Der Schwenkzapfen 21 weist einen Durchmesser auf, der im wesentlichen der Weite des Auges 13 in dessen kurzer Achse entspricht. Im Schwenkzapfen 21 ist ein Federlager 22 vorgesehen, in welchem eine Feder 23 befestigt ist. Die Feder 23 ist hierbei so ausgebildet, daß sie den Aufstellfuß nach oben, also in entgegengesetzter Richtung zu einer Unterlage 2 drückt, auf welcher das Gehäuse 1 aufgestellt werden soll.

In der Seitenwand 3 ist eine Nut 5 vorgesehen, die senkrecht über dem Lagerzapfen 21 und senkrecht unter dem Lagerzapfen 21 mit einer jeweils nach unten offenen Kerbe 32, 32' in Verbindung steht.

Der Aufstellfuß 10 weist zwei in Richtung auf die Seitenwand 3 ragende Zapfen 31, 31' auf, welche derart geformt sind, daß sie zum einen in der Nut 5 verschoben, andererseits in die Kerben 32, 32' eingerastet werden können. Die Zapfen 31, 31' und die Kerben 32, 32' bilden Arretiereinrichtungen 30, 30', welche den Aufstellfuß 10 entweder in der in den Fig. 1 und 2 gezeigten Position oder aber in einer Position arretieren können, in welcher die Fußfläche 12 anstelle der Fußfläche 11 auf die Unterlage 2 aufsetzbar ist.

In der in Fig. 1 gezeigten Position (oder in der oben beschriebenen umgekehrten Position) wird der Aufstellfuß 10 auch dann gehalten, wenn man das Gehäuse 1 hochhebt und die Fußfläche 11 von der Unterlage 2 freikommt, da die Feder 23 den Aufstellfuß nach oben, in das Gehäuse hinein drückt. Dadurch ist gewährleistet, daß der Lagerzapfen 21 entweder an dem der Fußfläche 11 zugewandten Ende 14' des Lagerauges 13 oder aber an dem gegenüberliegenden, der Fußfläche 12 zugewandten Ende 14 des Lagerauges 13 anliegt.

Will man nun den Aufstellfuß 10 aus seiner in Fig. 1 gezeigten Position herausschwenken, um ihn entweder horizontal zu stellen (beide Fußflächen 11 und 12 liegen dann im Gehäuseinneren), so zieht man den Fuß 10 nach unten, aus dem Gehäuse heraus, so daß die Zapfen 31, 31' aus den Kerben 32, 32' herausrutschen und der Aufstellfuß 10 um das Lager 20 verschwenkt werden kann, wobei dann die Zapfen 31, 31' in der Nut 5 gleiten. Diese zum Lösen der Arretierung notwendige Kraft ist also der Kraft F entgegengerichtet, welche auf die jeweils unten befindliche Fußfläche 11 (oder 12) durch das Gewicht des Gehäuses 1 beim Aufstellen auf eine Unterlage 2 wirkt. Dadurch kann es nicht geschehen, daß der Aufstellfuß 10 versehentlich eingeklappt wird, so daß das Gehäuse 1 auf die Unterlage 2 aufprallt.

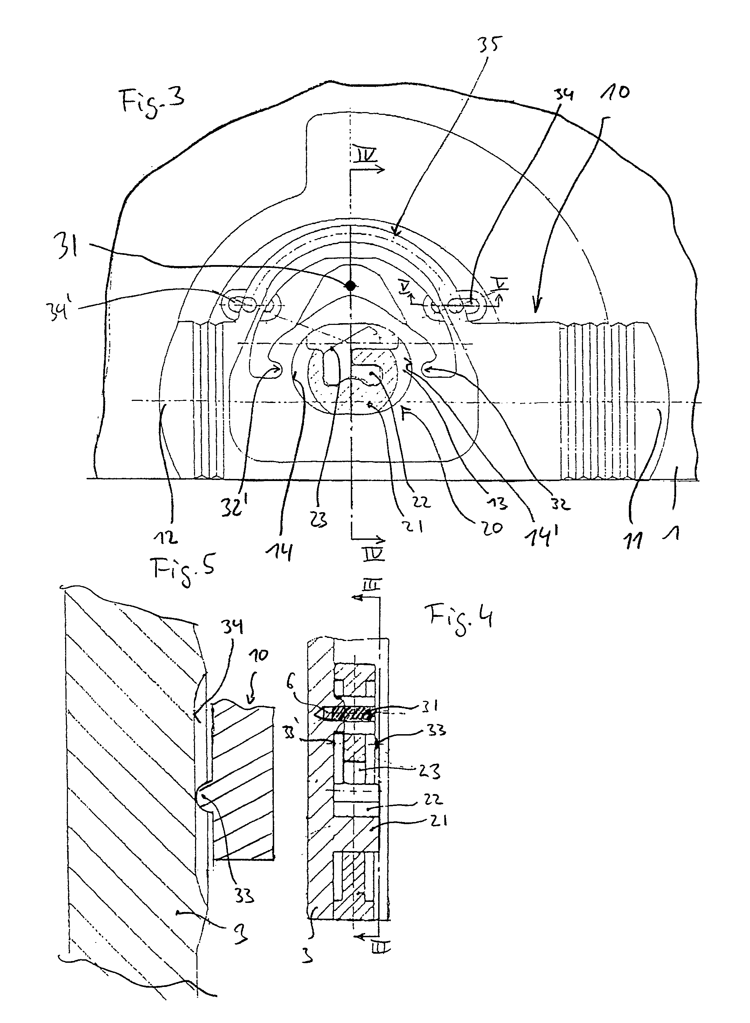

Bei der in den Fig. 3 bis 7 gezeigten bevorzugten Ausführungsform sind gleiche oder gleichwirkende Teile mit denselben Bezugsziffern versehen und werden darum nicht nochmals näher erläutert.

Bei der zweiten Ausführungform der Erfindung ist zur Bildung des Zapfens 31 ein Stahl-Stift in eine Paß-Bohrung 6 in der Seitenwand 3 eingepreßt, die als Aluminium-Druckgußteil geformt ist.

Der Aufstellfuß 10 weist zwei in Richtung auf das Auge 13 geschlossene Kerben 32, 32' auf. Das Auge 13 ist hierbei seitlich der Längsachse des Fußes 10, also der Achse, welche die Mitten der Fußflächen 11 und 12 verbindet, angeordnet.

Weiterhin ist der Lagerzapfen 21 an seiner Unterseite abgeflacht ausgebildet, so daß diese flache Seite dann, wenn der Aufstellfuß 10 in der in Fig. 3 gezeigten Position in das Gehäuse eingeklappt ist, auf der geradlinigen Seite des Langloch-Auges 13 durch die Kraft der Feder 23 gehalten wird. Dadurch ist bereits eine gewisse Arretierung des Aufstellfußes 10 in der in Fig. 3 gezeigten Null-Position gewährleistet.

Es sind zusätzliche Einrichtungen vorgesehen, um den Aufstellfuß 10 in seiner Null-Position (Fig. 3) zu halten. Diese umfassen einen am Aufstellfuß 10 einstückig befestigten Bügel 35, der an seiner, der Gehäusewand 3 zugewandten Fläche und an seiner gegenüberliegenden Fläche jeweils eine im wesentlichen halbkugelförmige Arretierungsnase 33 bzw. 33' trägt. In der Innenfläche der Seitenwand 3 des Gehäuses sind kerbenförmige Arretierungsrasten 34, 34' derart vorgesehen, daß die Arretierungsnasen 33, 33' beim Verschwenken des Aufstellfußes 10 in die Arretierungsrasten 34, 34' einrasten können. Der Aufstellfuß 10 wird auf dem Lagerzapfen 21 ebenso wie bei der in den Fig. 1 und 2 gezeigten Ausführungsform mittels einer (in den Fig. 3 bis 7 nicht gezeigten) Haltescheibe 16 gehalten. Dadurch werden die Arretierungsnasen 33, 33' reibschlüssig auf der Innenfläche der Seitenwand 3 gehalten und in der Raststellung in die Arretierungsrasten 34, 34' unter (leichter) Verformung des Bügels 35 gedrückt.

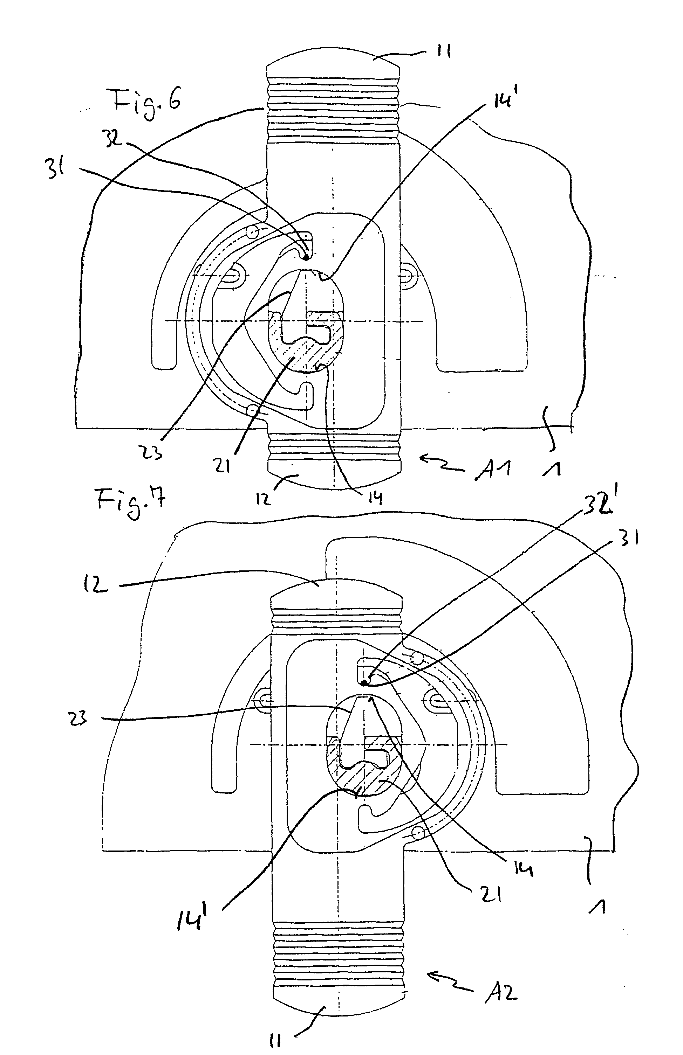

Die Funktionsweise dieser Ausführungsform der Erfindung entspricht derjenigen nach den Fig. 1 und 2, wobei die beiden Aufstellpositionen A1 (Fig. 6) und A2 (Fig. 7) ein Verschwenken des Aufstellfußes 10 aus der Null-Stellung (Fig. 3) nach links bzw. nach rechts voraussetzen. Um den Aufstellfuß aus seiner in den Fig. 6 und 7 gezeigten Position wieder zurückzubringen, muß er jeweils nach unten, entgegen der Kraft der Feder 23 gezogen werden, damit der Zapfen 31 aus der jeweiligen Kerbe 32 bzw. 32' schlüpfen kann, bevor eine Verschwenkbewegung möglich ist.

Bezugszeichenliste

| | |
|---|---|
| 1 | Gehäuse |
| 2 | Unterlage |
| 3 | Seitenwand |
| 4 | Boden |
| 5 | Nut |
| 6 | Paß-Bohrung |
| 10 | Aufstellfuß |
| 11 | Fußfläche |
| 12 | Fußfläche |
| 13 | Auge |
| 14 | Langloch-Ende |
| 16 | Haltescheibe |
| 20 | Lager |
| 21 | Lager-Zapfen |
| 22 | Federlager |
| 23 | Feder |
| 30 | Arretiereinrichtung |
| 31 | Zapfen |
| 32 | Kerbe |
| 33 | Nullstellungs-Arretierungsnase |
| 34 | Nullstellungs-Arretierungsraste |
| 35 | Bügel |

## Patentansprüche

1. Aufstellfuß für ein Gehäuse, insbesondere für ein 19''-Tischgehäuse, mit einem Lager (20) zum schwenkbeweglichen Lagern des Aufstellfußes (10) derart, daß der Aufstellfuß mindestens zwischen einer Null-Position, in welcher der Aufstellfuß (10) im wesentlichen vollständig im Gehäuse (1) aufgenommen ist, und einer Aufstellposition (A1, A2) verschwenkbar ist, in welcher der Aufstellfuß (10) mit einer Fußfläche (11, 12) aus dem Gehäuse (1) ragt und auf einer Unterlage (2) aufstellbar ist, verschwenkt werden kann, und mit Arretiereinrichtungen (30, 30') zum lösbaren Arretieren des Aufstellfußes (10) in den mindestens zwei Positionen, **dadurch gekennzeichnet,** daß die Arretiereinrichtungen (30, 30') derart ausgebildet sind, daß ein Lösen der Arretierung, um den Aufstellfuß (10) aus einer Aufstellposition (A1, A2) herauszubewegen, nur durch Bewegen des Aufstellfußes (10) in eine Richtung bewirkbar ist, welche entgegen einer von der Unterlage (2) auf die Fußfläche (11, 12) wirkenden Kraft (F) gerichtet ist.

2. Aufstellfuß nach Anspruch 1, dadurch gekennzeichnet, daß das Lager (20) ein Lagerauge (13) im Aufstellfuß (10) und einen Lagerzapfen (21) am Gehäuse (1) - oder umgekehrt - umfaßt.

3. Aufstellfuß nach Anspruch 2, dadurch gekennzeichnet, daß das Lagerauge (13) als Langloch und der Lagerzapfen (21) im wesentlichen zylindrisch mit einem Durchmesser entsprechend der kurzen Achse des Lagerauges (13) ausgebildet ist, wobei die lange Achse des Lagerauges (13) in Längsrichtung des Aufstellfußes (10), senkrecht zur Fußfläche (11, 12) verläuft.

4. Aufstellfuß nach Anspruch 3, dadurch gekennzeichnet, daß Federeinrichtungen (23) vorgesehen und derart angeordnet sind, daß der Aufstellfuß (10) in Richtung auf die Oberseite des Gehäuses, entgegengesetzt zur Aufstellunterlage (2) gedrückt wird.

5. Aufstellfuß nach einem der vorhergehenden Ansprüche, dadurch gekennzeichnet, daß die Arretiereinrichtungen (30, 30') mindestens einen am Gehäuse (1) befestigten Zapfen (31, 31') und mindestens eine im Aufstellfuß (10) angebrachte, einseitig offene Kerbe (32, 32') - oder umgekehrt - umfassen, die derart ausgebildet sind, daß in der (den) Aufstellposition(en) (A1, A2) der (die ) Zapfen (31, 31') in die Kerbe(n) (32, 32') einrastbar ist (sind).

6. Aufstellfuß nach einem der vorhergehenden Ansprüche, dadurch gekennzeichnet, daß der Aufstellfuß (10) mindestens zwei Fußflächen (11, 12) umfaßt und derart ausgebildet ist, daß eine Fußfläche (11) weiter vom Lager (20) entfernt ist als die andere(n) Fußfläche(n) (12) derart, daß mindestens zwei Aufstellpositionen (A1, A2) mit verschiedenen Höhen des Gehäuses (1) von der Unterlage (2) einstellbar sind.

7. Aufstellfuß nach einem der vorhergehenden Ansprüche, dadurch gekennzeichnet, daß zusätzliche Arretierungseinrichtungen (33, 34) vorgesehen und derart ausgebildet sind, daß der Aufstellfuß (10) in einer Null-Stellung derart arretierbar ist, daß die Fußfläche(n) (11, 12) im wesentlichen innerhalb des Gehäuses (1) liegt (liegen).

8. Aufstellfuß nach einem der vorhergehenden Ansprüche, dadurch gekennzeichnet, daß der Aufstellfuß (10) symmetrisch zu seiner Schwenkebene derart ausgebildet ist, daß er an einer beliebigen Gehäuseseitenwand (3) anbringbar ist.

Fig. 2

Fig. 1

EP 0 453 654 A1

Fig.3

Fig.5

Fig.4

7

EP 0 453 654 A1

Fig. 6

Fig. 7

8

Fig. 8

# EUROPÄISCHER RECHERCHENBERICHT

Nummer der Anmeldung

**EP 90 12 5198**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 625 595 (PENDAR) <br> — — — | | F 16 M 7/00 <br> H 05 K 5/02 |
| A | DE-U-7 624 641 (SCHROFF) <br> — — — | | |
| A | GB-A-2 173 545 (TELENOVA) <br> — — — | | |
| A | US-A-4 592 528 (STILL) <br> — — — — — | | |

**RECHERCHIERTE SACHGEBIETE (Int. Cl.5)**

F 16 M
H 05 K

Der vorliegende Recherchenbericht wurde für alle Patentansprüche erstellt

| Recherchenort | Abschlußdatum der Recherche | Prüfer |
|---|---|---|
| Den Haag | 29 Juli 91 | BARON C. |